# EUROPÄISCHE PATENTSCHRIFT

(11) **EP 1 229 278 B1**
(45) Veröffentlichungstag und Bekanntmachung des Hinweises auf die Patenterteilung: **12.10.2005**
(21) Anmeldenummer: 02002346.1
(22) Anmeldetag: 31.01.2002
(51) Int. Cl.: F16K 31/00

(54) **Piezoelektrischer Aktor**
Piezoelectric actuator
Actionneur piézo-électrique

(30) Priorität: 31.01.2001 US 265753 P
(43) Veröffentlichungstag der Anmeldung: 07.08.2002
(73) Patentinhaber: CATERPILLAR INC., Illinois 61629-6490 (US)
(72) Erfinder: Schmauser, Erik M., 91126 Schwabach (DE); Schmauser, Till M., 91126 Schwabach (DE); Dollgast, Bernhard, 91054 Erlangen (DE)
(74) Vertreter: Wagner & Geyer

(56) Entgegenhaltungen:
- EP-A- 0 922 893
- DE-A- 3 608 550
- DE-A- 19 720 849
- US-A- 5 628 411
- PATENT ABSTRACTS OF JAPAN vol. 009, no. 206 (M-406), 23. August 1985 (1985-08-23) & JP 60 065970 A (SHIYOUKETSU KINZOKU KOGYO KK), 15. April 1985 (1985-04-15)

## Beschreibung

Die Erfindung bezieht sich auf einen piezoelektrischen Aktor mit einem piezoelektrischen Biegewandler. Sie bezieht sich weiter auf ein mit einem solchen Aktor betätigbares Ventil.

Beim Einsatz derartiger Aktoren ist der piezoelektrische Biegewandler entweder nur an einem Ende oder aber an beiden Enden fest eingespannt. So ist beispielsweise aus der DE 36 08 550 A1 ein als Pneumatik- oder Hydraulikventil verwendbares Ventil bekannt, bei dem innerhalb eines Ventilgehäuses ein piezoelektrischer Biegewandler mit dessen zum Anschließen einer elektrischen Spannungsquelle dienenden Anschlussende in einer Gehäuseschmalseite fixiert ist, während das gegenüberliegende Freiende des Biegewandlers, das ein Dichtelement zum Verschließen eines Ventilkanals trägt, in den Gehäuseinnenraum hineinragt.

Demgegenüber weist ein aus der US 5,630,440 bekanntes piezoelektrisch betätigtes Ventil einen beidendseitig im Gehäuse eingeklemmten und somit mit dessen beiden Enden fixierten Biegewandler auf. Dadurch wird gegenüber einer Fixierung lediglich eines Endes des Biegewandlers zwar eine vergleichsweise hohe Rückstell- oder Arbeitskraft erzielt. Allerdings hat die beidendseitige Fixierung des Biegewandlers den erheblichen Nachteil eines nur geringen und daher in der Regel unzureichenden Auslenkungsweges oder Biegungshubs.

Ferner ist aus der JP-A-60 065 970 ein piezoelektrischer Aktor mit einem piezoelektrischen Biegewandler bekannt, dessen gegenüberliegenden Enden in Wandlerlängsrichtung beweglich geführt sind.

Der Erfindung liegt daher die Aufgabe zugrunde, einen piezoelektrischen Aktor anzugeben, der beim bestimmungsgemäßen Betrieb möglichst zuverlässig und effektiv arbeitet. Des Weiteren soll ein mit einem solchen Aktor besonders betriebssicher betätigbares Ventil, insbesondere ein Pneumatikventil, angegeben werden.

Bezüglich des Aktors wird die Aufgabe erfindungsgemäß gelöst durch die Merkmale des Anspruchs 1. Dazu ist das erste Ende des zweckmäßigerweise rechteckförmigen, plättchenartigen Biegewandlers drehbeweglich gehalten, während das gegenüberliegende zweite Ende in Wandlerlängsrichtung beweglich geführt ist. Aufgrund der Reversibilität des piezoelektrischen Effektes kann diese Anordnung prinzipiell auch für eine Verwendung als Sensor genutzt werden.

Die transversale Führung der einen Wandlerseite oder des einen Wandlerendes ermöglicht eine Längsbewegung des Biegewandlers beim Übergang vom Ruhezustand in den angeregten Zustand. Gleichzeitig wird durch die drehbewegliche Halterung der gegenüberliegenden Wandlerseite bzw. des gegenüberliegenden Wandlerendes ein Gegenmoment vermieden, das beim festen Einspannen und damit bei einer unbeweglichen Fixierung dieses Wandlerendes infolge der bestimmungsgemäßen Anregung des Biegewandlers zwangsläufig auftritt und zu einem Bruch des Wandlermaterials führen kann.

In vorteilhafter Ausgestaltung ist der piezoelektrische Biegewandler zumindest am drehbeweglich gehaltenen Wandlerende, zweckmäßigerweise jedoch beidendseitig, in ein zylinderförmiges Halteelement geführt und mit diesem fest verbunden. Dabei ist das am rotatorisch gelagerten oder gehaltenen Fixierende des Biegewandlers vorgesehene Halteelement in eine entsprechend runde oder kreisförmige Aufnahmenut eingelegt, die das zylinderförmige Halteelement um vorzugsweise mehr als die halbe Querschnittsfläche bzw. mehr als 180° umgreift. Diese Aufnahmenut, die vorzugsweise eine Gehäusenut ist, kann sich über die gesamte Länge des zylindrischen Halteelements erstrecken. Auch kann die entsprechende Aufnahme- oder Gehäusenut das Halteelement nur lokal, z.B. nur im mittleren und/oder äußeren Bereich, umgreifen. Das drehbar gehaltene Wandlerende ist zweckmäßigerweise als mit einer elektrischen Spannungsquelle verbindbares Anschlussende zur Aktor- bzw. Wandlerbetätigung ausgeführt.

Analog kann auch das am - bezogen auf die Ausbiegungsrichtung des Biegewandlers - transversal verschiebbaren Ende des Biegewandlers vorgesehene Halteelement über dessen gesamte axiale Länge oder nur mit Teilbereichen in einer entsprechenden, zweckmäßigerweise etwa U-förmigen Aufnahme- bzw. Gehäusenut eingelegt sein.

Bezüglich des mit einem solchen piezoelektrischen Aktor betätigbaren Ventil wird die genannte Aufgabe erfindungsgemäß gelöst durch die Merkmale des Anspruchs 5. Vorteilhafte Ausgestaltungen sind Gegenstand der auf diesen rückbezogenen Unteransprüche.

Mit einem einen solchen piezoelektrischen Aktor aufweisenden Ventil wird ein zuverlässiges Verschließen des zu sperrenden und somit jeweils deaktivierten Ventilkanals auch unter extremen Betriebsbedingungen, insbesondere bei einem hohen Druck und einer hohen Strömungsgeschwindigkeit eines zu steuernden Mediumflusses, durch Erhöhung der Kraft bei gleichzeitig möglichst großem Auslenkungsweg bzw. Biegehub erreicht. Diese erhöhte Andruck- oder Anpresskraft, mit der das Dichtelement mittels des piezoelektrischen Biegewandlers des Aktors gegen den Ventilsitz des entsprechenden Ventilkanals gepresst oder gedrückt wird, kann bei gleichzeitig ausreichendem Auslenkungsweg durch den Biegewandler selbst erzeugt werden, da dieser innerhalb des Ventilgehäuses erfindungsgemäß beidendseitig gehalten und dabei lediglich an einem Wandlerende ortsfest ist, während das andere Wandlerende quasi schwimmend gehalten ist und somit nach Art eines Widerlagers lediglich unterstützt wird. Dadurch wird insgesamt eine Verbesserung des Betriebsverhaltens des Aktors als solchem und in dessen Verwendung zur Betätigung eines Ventils zudem eine Erhöhung der Betriebssicherheit des Ventils erzielt.

Die Erfindung geht dabei von der Erkenntnis aus, dass bei gegebener Anschluss- oder Betriebsspannung und demzufolge bei konstantem Biegemoment des piezoelektrischen Wandlers die von diesem erzeugte Kraft mit abnehmendem Hebelarm zunimmt. Wird somit der Biegewandler beidendseitig gehalten, so ist die infolge einer Ausbiegung des Biegewandlers von diesem ausgeübte Ausbiegungskraft, die bei der Ventilanwendung als vom Dichtelement auf den Ventilsitz des entsprechenden Ventilkanals ausgeübte Anpresskraft wirksam ist, im Vergleich zu einem einseitig eingespannten und freiendseitig freibeweglichen Biegewandler deutlich größer. Wird dabei das eine Wandlerende axialbeweglich geführt, so ist gleichzeitig der Auslenkungsweg größer als bei einem beidendseitig fixierten Biegewandler. Wird darüber hinaus das ortsfeste Wandlerende drehbeweglich gehalten, so ist gegenüber einer unbeweglichen Fixierung durch Einspannen dieses Wandlerendes ein entsprechendes Gegenmoment und damit eine Sollbruchstelle an diesem Fixierende des Biegewandlers vermieden.

Der Biegewandler ist vorteilhafterweise im spannungslosen Zustand gebogen ausgeführt. Zur Ventilsteuerung ist diese Ausbiegung oder -wölbung in Richtung auf den Ventilkanal konkav. Mit anderen Worten: Zur Ventilsteuerung ist diese Ausbiegung oder-wölbung zu demjenigen Kanal hin orientiert, der im Ruhezustand deaktiviert und verschlossen sein soll. Dadurch wird bereits im Ausgangs- oder Ruhezustand ein zuverlässiges Verschließen des Ventilkanals in besonders einfacher und wirkungsvoller Art und Weise erzielt. Auch können innerhalb des Ventilgehäuses zwei solche Aktoren mit entsprechend zwei derart gehaltenen und zueinander im Wesentlichen parallel verlaufend angeordneten Biegewandlem vorgesehen sein.

Der Biegungsverlauf des Biegewandlers im spannungslosen oder erregungsfreien Ruhezustand wird zweckmäßigerweise dadurch erreicht, dass der Biegewandler selbst blattfederartig vorgespannt ist. Eine derartige Vorspannung wiederum wird zweckmäßigerweise durch ein geeignetes Herstellungsverfahren erreicht. Dabei wird von einem lamellierten Biegewandler mit einem zumindest eine elektrisch leitfähige Trägerschicht und eine Piezokeramikschicht aufweisenden Schichtaufbau ausgegangen, der durch Erhitzen und anschließendes Abkühlen infolge materialbedingt unterschiedlicher Kontraktionseigenschaften zu verschieden stark vorgespannten Schichten oder Lagen (prestressed layers) führt. Die unterschiedliche Vorspannung der Schichten wiederum führt zu einer Ausbiegung des flachen Biegewandlers um eine quer zu dessen Längsseiten verlaufende und parallel zu dessen Schmalseiten liegende Biegeachse.

Die mit der Erfindung erzielten Vorteile bestehen insbesondere darin, dass mittels eines Aktors, dessen vorzugsweise gewölbter und vorgespannter piezoelektrischer Biegewandler an einem Wandlerende schwimmend gelagert und am gegenüberliegenden Wandlerende drehbeweglich gehalten ist, bei gleichzeitig langer Lebensdauer und zuverlässigem Betriebsverhalten einerseits ein großer Auslenkungsweg bzw. Biegungshub und andererseits eine besonders hohe Rückstell- bzw. Arbeitskraft erreicht wird. Daher ist bei einem mittels eines solchen Aktors piezoelektrisch betätigten Ventil die Dichtwirkung eines geschlossenen oder zu schließenden Ventilkanals und damit die Betriebssicherheit des Ventils erheblich erhöht.

Nachfolgend werden Ausführungsbeispiele der Erfindung anhand einer Zeichnung näher erläutert. Darin zeigen:
- Fig. 1: in perspektivischer Darstellung einen erfindungsgemäßen piezoelektrischen Aktor mit beidendseitig in Aufnahmenuten gehaltenem Biegewandler,
- Fig. 2: in einer Darstellung gemäß Fig. 1 einen am drehbeweglichen Wandlerende lokal gehaltenen Biegewandler,
- Fig. 3: einen Biegewandler gemäß Fig. 2 mit über eine Drehachse gehaltenem Wandlerende, und
- Fig. 4: in einer Schnittdarstellung ein Ventil mit einem erfindungsgemäßen Aktor.

Dabei sind gleiche Teile in allen Figuren mit den gleichen Bezugszeichen versehen.

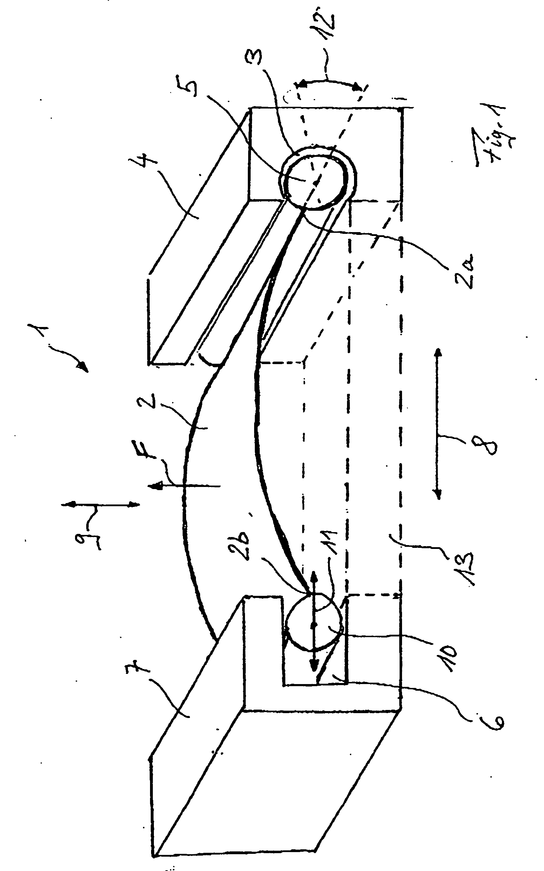

Fig. 1 zeigt einen piezoelektrischen Aktor 1 mit einem plättchenförmigen, insbesondere rechteckigen, Biegewandler 2 mit einem Anschlussende 2a und einem Freiende 2b. Das nachfolgend als erstes Wandlerende bezeichnete Anschlussende 2a des Biegewandlers 2 ist in einer etwa kreisförmigen Aufnahmenut 3 eines Gehäuseblocks 4 drehbeweglich gehalten. Dazu trägt der Biegewandler 2 an diesem Wandlerende 2a ein (erstes) zylinderförmiges Halteelement 5, das von der Aufnahmenut 3 umfangsseitig nicht vollumfänglich, jedoch vorzugsweise um mehr als 180°, umgriffen ist. An dieses Wandlerende 2a können in nicht näher dargestellter Art und Weise Anschlusskontakte geführt sein, die mit einer Spannungsquelle zur Ansteuerung des Biegewandlers 2 und damit des Aktors 1 über Anschlussleitungen verbunden sind.

Das gegenüberliegende (zweite) Wandlerende 2b ist in einer etwa U-förmigen Aufnahmenut 6 eines weiteren Gehäuseblocks 7 gehalten und dort in Wandlerlängsrichtung 8 verschiebbar geführt. Bezogen auf die in Richtung der Arbeitskraft F des Biegewandlers 2 verlaufende Ausbiegerichtung 9 ist dieses zweite Wandlerende 2b somit transversal verschiebbar gehalten. Auch an diesem Wandlerende 2b trägt der Biegewandler 2 ein (zweites) zylinderförmiges Halteelement 10, das in der einen - bezogen auf die Wandlerlängsrichtung 8 - oberen und unteren Anschlag bildenden Aufnahmenut 6 praktisch schwimmend gelagert ist. Anstelle eines zylinderförmigen Halteelementes 5,10 kann auch eine eingeprägte Vertiefung eines Mittelbleches des Biegewandlers 2 nach Art einer Sicke als Halteelement vorgesehen sein. Wichtig ist eine momentfreie, längsverschiebbare Halterung.

Beim bestimmungsgemäßen Betrieb des Aktors 1 und damit im erregten Zustand des Biegewandlers 2 bewegt sich dieser in Ausbiegerichtung 9, wobei sich das in Fig. 1 linke (zweite) Wandlerende 2b entlang der Pfeilrichtung 11 in Wandlerlängsrichtung 8 innerhalb der Aufnahmenut 6 bewegen kann. Gleichzeitig kann sich das in der Aufnahmenut 3 drehbeweglich gehaltene rechte (erste) Wandlerende 2a in Pfeilrichtung 12 rotatorisch bewegen. Durch die Ansteuerung des Biegewandlers 2 vergrößert oder verkleinert sich dessen Krümmung oder Wölbung. Durch die drehbare Lagerung des Wandlerendes 2a und die transversal verschiebbare Lagerung des Wandlerendes 2b kann sich der Wandler 2 ohne die Ausbildung von Eigenspannungen in den Lagern oder Ausnehmungen 3,6 bzw. ohne Gegenmoment in der Ausnehmung 3 an die neue Krümmung anpassen. Bei der vorzugsweise mittigen Ausleitung der Arbeitskraft F entstehen ebenfalls keine Eigenspannungen bzw. Gegenmomente in den beiden Ausnehmungen 3,6. Die Arbeitskraft F wird vorzugsweise im mittleren Bereich des Biegewandlers 2 abgegriffen, da diese aufgrund der beidendseitigen Halterung des Biegewandlers 2 in dessen Mitte am größten ist.

Wie gestrichelt dargestellt ist, können die beiden Gehäuseblöcke 4, 7 auch als Gehäuseeinheit ausgeführt sein. Dazu sind die beiden Gehäuseblöcke 4 und 7 zweckmäßigerweise auf der Gehäuseunterseite, zu der der Biegewandler 2 konvex gebogen oder gewölbt ist, miteinander über einen stegartigen Gehäuseabschnitt 13 miteinander verbunden. Der dargestellte Biegungs- oder Krümmungsverlauf des Biegewandlers 2 wird durch ein spezielles Herstellungsverfahren erreicht, bei dem in nicht näher dargestellter Art und Weise ein Schichtaufbau mit einer elektrisch leitfähigen Trägerschicht, vorzugsweise in Form eines flachen Blechstreifens, und mit einer darauf adhäsiv gehaltenen Piezokeramikschicht durch Erhitzen und anschließendes Abkühlen entlang der Wandlerlängsrichtung 8 vorgespannt wird.

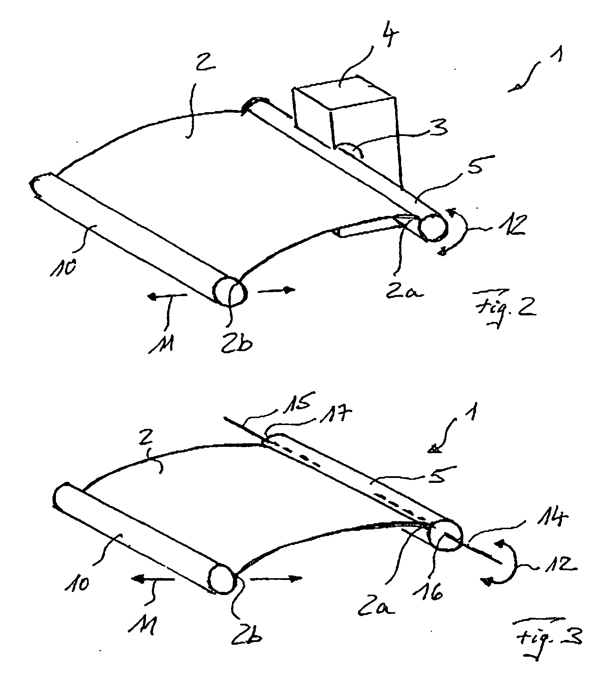

Bei der Ausführungsform gemäß Fig. 2 erstreckt sich die Aufnahmenut 3 lediglich über einen Teil der axialen Länge des zylinderförmigen Halteelementes 5 am drehbar gehaltenen Wandlerende 2a. Hierzu ist der Gehäuseblock 4 gegenüber der Ausführungsform nach Fig. 1 entsprechend verkleinert ausgeführt. Auch können anstelle eines einzelnen Gehäuseblocks 4 mit einer das zylindrische Halteelement 5 am drehbeweglichen Wandlerende 2a etwa im mittleren Bereich umgreifenden Aufnahmenut 3 auch beispielsweise zwei derartige Gehäuseblöcke 4 vorgesehen sein, deren Aufnahmenuten 3 dann das Halteelement 5 im Bereich dessen beiden Stirnenden umgreifen. Ebenso wie bei der Ausführungsform gemäß Fig. 1 weist der oder jeder lokal wirksame Gehäuseblock 4 wiederum eine kreisförmige oder runde, umfänglich nicht vollständig geschlossene Aufnahmenut 3 auf, an deren Öffnungsseite wiederum der Biegewandler 2 austritt.

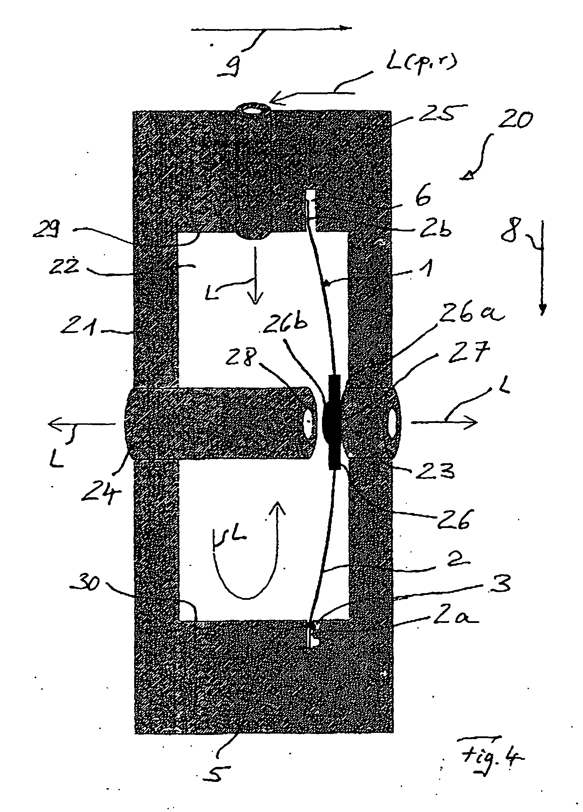

Gemäß der Ausführungsform nach Fig. 3 ist eine Drehlagerung des am drehbeweglichen Wandlerende 2a vorgesehenen zylinderförmigen Halteelements 5 nach Art einer Welle vorgesehen. Hierzu greifen zwei Drehwellen oder Wellenfortsätze 14,15 stirnseitig in entsprechende Bohrungen 16 bzw. 17 des zylinderförmigen Halteelements 5 ein. Die beiden Wellenfortsätze 14,15 führen dann in nicht näher dargestellter Art und Weise den Plus- bzw. Minuspol einer Ansteuerelektronik für die Ansteuerung des piezoelektrischen Aktors 1.

Fig. 4 zeigt ein mit einem solchen piezoelektrischen Aktor 1 betätigtes Ventil 20, das ein vorzugsweise aus Kunststoff bestehendes und quaderförmiges Ventilgehäuse 21 mit einem ebenfalls quaderförmigen oder auch kreiszylindrischen Innenraum 22 aufweist. In den Innenraum 22 münden zwei sich diametral gegenüberliegende Ventilkanäle 23 und 24 ein. Ein weiterer in den Innenraum 22 des Ventilgehäuses 21 einmündender Ventil- oder Eintrittskanal 25 verläuft im Ausführungsbeispiel quer zu den beiden Ventilkanälen 23 und 24.

Bei dem ohne Spannungsanschlüsse dargestellten Ventil 20 ist der Biegewandler 2 im Ventilgehäuse 21 wiederum beidendseitig gehalten. Dabei ist wiederum das Wandlerende 2a mittels des an diesem befestigten, im Querschnitt kreisförmigen Halteelement 5 in einer entsprechenden Aufnahme- oder Gehäusenut 3 drehbeweglich gehalten, während das gegenüberliegende Wandlerende 2b wiederum in einer entsprechenden Aufnahme- bzw. Gehäusenut 6 längsverschiebbar, d. h. in Wandlerlängsrichtung 8 verschiebbar oder transversal beweglich und somit schwimmend gelagert ist. Beim Ausführungsbeispiel ist dieses Wandlerende 2b direkt, d. h. ohne zusätzliches Halteelement in die Gehäusenut 6 eingeführt. Dabei ist das Wandlerende 2b derart geringfügig abgebogen, dass dieses zumindest annähernd parallel zu den Nutwänden der wiederum etwa U-förmigen, länglichen Gehäusenut 6 verläuft.

Im Ausführungsbeispiel ist der mittlere Bereich des Biegewandlers 2 im Ruhezustand in Richtung auf den Ventilkanal 23 gewölbt oder gebogen. In diesem mittleren Bereich ist auf den Biegewandler 2 ein Dichtelement 26 aufgesetzt oder aufgeschoben, das zweckmäßigerweise beidseitig gewölbt ausgeführt und sowohl auf der konvexen als auch auf der konkaven Seite des Biegewandlers 2 wirksam ist. Einander entgegengerichtete Dichtwölbungen 26a,26b sind dabei zweckmäßigerweise halbkugelförmig ausgebildet. Dadurch wird insbesondere auch bei einer vergleichsweise kleinen lichten Weite oder einem vergleichsweise kleinen Innendurchmesser der Ventilkanäle 23,24 eine besonders zuverlässige Dichtwirkung erzielt. Der dem Ventilkanal 23 gegenüberliegende Ventilkanal 24 ist im Gehäuseinnenraum 22 in Richtung zum Dichtelement 26 hin verlängert und erstreckt sich somit bis in die wirksame Nähe des Biegewandlers 2.

Beim Betrieb des im Ausführungsbeispiel als Drei-Wege-Ventil ausgeführten Pneumatikventils 20 wird mittels des spannungslosen und somit erregungsfreien Biegewandlers 2 das Dichtelement 26 gegen einen Ventilsitz 27 gepresst und somit der Ventilkanal 23 verschlossen, während der Ventilkanal 24 geöffnet ist. Die dazu erforderliche Arbeits- oder Anpresskraft F wird vom Biegewandler 2 selbst dadurch aufgebracht, dass dieser im Ruhezustand in Richtung auf den Ventilsitz 27 konkav gewölbt und dabei durch eine entsprechende Einbaulage blattfederartig vorgespannt ist. Durch Umpolen der Spannung, z. B. einer Gleichspannung von 200V, werden infolge einer Ausbiegung des Biegewandlers 2 entgegen der dargestellten Biegerichtung 9 der Ventilkanal 24 durch Anpressen des Dichtelementes 26 an einen Ventilsitz 28 geschlossen und gleichzeitig der Ventilkanal 23 geöffnet.

Über den Eintritts- oder Einlasskanal 25 in das Ventilgehäuse 21 mit einem vorgegebenen Druck p und mit einer vorgegebenen Strömungsgeschwindigkeit v einströmende Luft L wird über den in diesem spannungslosen Ruhezustand geöffneten Ventilkanal 24 aus dem Ventilgehäuse 21 abgeführt. Der Einströmkanal 25 mündet über die mit der länglichen Gehäusenut 6 für das transversal beweglich gehaltene Wandlerende 2b versehene Gehäuseseite oder Schmalseite 29 des Ventilgehäuses 21 in den Innenraum 22 ein. Auch kann der Einströmkanal 25 über die gegenüberliegende, mit der runden Gehäusenut 3 für das drehbeweglich gehaltene Wandlerende 2a versehene Gehäuseseite oder Schmalseite 30 des Ventilgehäuses 21 in dessen Innenraum 22 geführt sein. Die über den Einlasskanal 25 in das Ventilgehäuse 21 einströmende Luft L wird über den Ventilkanal 24 oder - durch entsprechende Polung der Spannungsquellen - über den Ventilkanal 23 abgeführt.

Durch die Anordnung eines erfindungsgemäß beidendseitig gehaltenen Biegewandlers 2 innerhalb eines somit piezoelektrisch betätigten Ventils 20 wird gegenüber einem einseitig eingespannten Piezoelement oder Biegewandler eine Erhöhung der Kraft F zum Verschließen des Ventilkanals 23 bzw. 24 um ein Vielfaches erreicht. Während im Ruhezustand aufgrund der Vorspannung des gebogenen Biegewandlers 2 das von diesem getragene Dichtelement 26 bereits mit einer ausreichend hohen Anpresskraft F gegen den Ventilsitz 27 gedrückt wird, wird die zum Verschließen des im Ruhezustand offenen Ventilkanals 24 erforderliche Anpresskraft F durch die beidendseitige Halterung des Biegewandlers 2 in Kombination mit der mittenlagigen Anordnung des Dichtelements 26 erreicht. Grund hierfür ist eine Krafterhöhung infolge einer besonders günstigen Hebelarmwirkung bei konstantem Biegemoment. Eine Sollbruchstelle infolge eines Gegenmoments im Bereich des ortsfest gehaltenen Wandlerendes 2a ist auch hier durch die drehbewegliche Lagerung dieses Wandlerendes 2a zuverlässig vermieden.

### Bezugszeichenliste

- 1: Aktor
- 2: Biegewandler
- 2a: erstes Wandlerende
- 2b: zweites Wandlerende
- 3: Aufnahme-/Gehäusenut
- 4: Gehäuseblock
- 5: Halteelement
- 6: Aufnahme-/Gehäusenut
- 7: Gehäuseblock
- 8: Wandlerlängsrichtung
- 9: Ausbiegerichtung
- 10: Halteelement
- 11,12: Pfeilrichtung
- 13: Gehäuseabschnitt
- 14,15: Drehwelle
- 16,17: Bohrung
- 20: Ventil
- 21: Ventilgehäuse
- 22: Innenraum
- 23,24: Ventilkanal
- 25: Eintritts-Nentilkanal
- 26: Dichtelement
- 26a,b: Dichtwölbung
- 27,28: Ventilsitz
- 29,30: Gehäuse-/Schmalseite
- L: Luft
- F: Arbeits-/Anpresskraft

## Patentansprüche

1. Piezoelektrischer Aktor (1) mit einem piezoelektrischen Biegewandler (2), **dadurch gekennzeichnet, dass** dessen erstes Wandlerende (2a) drehbeweglich gehalten ist, und dessen dem ersten Wandlerende (2a) gegenüberliegendes zweites Wandlerende (2b) in Wandlerlängsrichtung (8) beweglich geführt ist.

2. Piezoelektrischer Aktor nach Anspruch 1,
**dadurch gekennzeichnet,**
**dass** am ersten Wandlerende (2a) des Biegewandlers (2) ein zylinderförmiges Halteelement (5) vorgesehen ist, das von einer Aufnahmenut (3) umfangsseitig zumindest teilweise umgriffen ist.

3. Piezoelektrischer Aktor nach Anspruch 1 oder 2,
**dadurch gekennzeichnet,**
**dass** am zweiten Wandlerende (2b) des Biegewandlers (2) ein zylinderförmiges Halteelement (10) vorgesehen ist, das von einer Aufnahmenut (6) bezogen auf die Ausbiegungsrichtung (9) des Biegewandlers (2) transversal verschiebbar aufgenommen ist.

4. Piezoelektrischer Aktor nach einem der Ansprüche 1 bis 3,
**dadurch gekennzeichnet,**
**dass** das erste Wandlerende (2a) als mit einer elektrischen Spannungsquelle verbindbares Anschlussende des Biegewandlers (2) zu dessen Betätigung ausgeführt ist.

5. Piezoelektrisch betätigbares Ventil (20) mit einem piezoelektrischen Aktor (1) nach einem der vorhergehenden Ansprüche, und mit mindestens einem Ventilkanal (23,24), der mittels eines am piezoelektrischen Biegewandler (2) gehaltenen Dichtelementes (26) verschließbar ist, wobei das erste Wandlerende (2a) des Biegewandlers (2) in einer im Ventilgehäuse (21) auf einer Gehäuseseite (30) vorgesehenen ersten Gehäusenut (3) drehbeweglich gehalten ist, und wobei das zweite Wandlerende (2b) des Biegewandlers (2) auf der dem ersten Wandlerende (2a) gegenüberliegenden Gehäuseseite (29) in einer zweiten Gehäusenut (6) in Wandlerlängsrichtung (8) beweglich geführt ist.

6. Piezoelektrisch betätigbares Ventil nach Anspruch 5,
**dadurch gekennzeichnet,**
**dass** der Biegewandler (2) im spannungslosen Zustand in Richtung auf einen ersten Ventilkanal (23) konkav gebogen ist.

7. Piezoelektrisch betätigbares Ventil nach Anspruch 6,
**dadurch gekennzeichnet,**
**dass** sich der zweite Ventilkanal (24) innerhalb des Ventilgehäuses (21) bis in die wirksame Nähe des Biegewandlers (2) erstreckt.

8. Piezoelektrisch betätigbares Ventil nach einem der Ansprüche 5 bis 7,
**dadurch gekennzeichnet,**
**dass** das Dichtelement (26) im mittleren Bereich des Biegewandlers (2) angeordnet ist.

9. Piezoelektrisch betätigbares Ventil nach Ansprüche 8,
**gekennzeichnet durch**
ein beidseitig des mittleren Bereichs des Biegewandlers (2) wirksames Dichtelement (26).

10. Piezoelektrisch betätigbares Ventil nach Anspruch 8 oder 9,
**dadurch gekennzeichnet,**
**dass** das Dichtelement (26) eine auf den jeweiligen Ventilkanal (23,24) gerichtete Dichtwölbung (26a bzw. 26b) aufweist.

## Claims

1. Piezoelectric actuator (1) having a piezoelectric bending transducer (2), **characterized by** the transducer having a first transducer end (2a) held in a rotatable manner and having a second transducer end (2b) being situated opposite the first transducer end (2a) which is guided to be movable in a longitudinal direction of the transducer.

2. Piezoelectric actuator of claim 1, **characterized in that**
a cylindrical retaining element (5) is provided at said first transducer end (2a) of said bending transducer (2), the cylindrical retaining element being at least partially surrounded on a peripheral side by a first receiving groove (3).

3. Piezoelectric actuator of claim 1 or 2, **characterized in that**
a second cylindrical retaining element (10) is provided at said second transducer end (2a) of said bending transducer (2), the second cylindrical retaining element being received by a receiving groove (6) in a transversely displaceable manner with respect to a deflection direction (9) of the bending transducer (2).

4. Piezoelectric actuator of one of claims 1 to 3, **characterized in that**
said first transducer end (2a) is configured as a terminal end of said bending transducer (2) such that the terminal end is connectable to an electrical voltage source for activation thereof.

5. Piezoelectrically actuatable valve (20) having a piezoelectric actuator (1) according to one of the preceding claims and having at least one valve channel (23, 24) configured to be closed by a sealing element (26) which is supported by the piezoelectric bending transducer (2), wherein said first transducer end (2a) of said bending transducer (2) is held in a rotatable manner in a first housing groove (3) provided in a housing side (30) of a valve housing (21), and wherein said second transducer end (2a) of said bending transducer (2) is guided to be movable in a longitudinal direction (8) of the transducer in a second housing groove (6) provided in a housing side (29) being situated opposite the first transducer end (2a).

6. Piezoelectrically actuatable valve of claim 5, **characterized in that**
the bending transducer (2) is concavely bent in the direction of a first valve channel (23) in an idle state.

7. Piezoelectrically actuatable valve of claim 6, **characterized in that**
a second valve channel (24) extends within the valve housing (21) into an effective vicinity of the bending transducer (2).

8. Piezoelectrically actuatable valve of one of claims 5 to 7, **characterized in that**
said sealing element (26) is situated in a middle region of the bending transducer (2a).

9. Piezoelectrically actuatable valve of claim 8, **characterized by** a sealing element (26) being effective on both sides of the middle region of the bending transducer (2).

10. Piezoelectrically actuatable valve of claim 8 or 9, **characterized in that**
said sealing element (26) includes a sealing convexity (26a and 26b, respectively) directed at the respective valve channel (23, 24).

## Revendications

1. Actionneur (1) piézoélectrique, avec un convertisseur de flexion (2) piézoélectrique, **caractérisé en ce que** sa première extrémité de convertisseur (2a) est maintenue de manière mobile en rotation, et sa deuxième extrémité de convertisseur (2b), opposée à la première extrémité (2a), est guidée de façon mobile dans la direction longitudinale (8) du convertisseur.

2. Actionneur piézoélectrique selon la revendication 1, **caractérisé en ce que**, sur la première extrémité de convertisseur (2a) du convertisseur de flexion (2), est prévu un élément de maintien (5) en forme de cylindre, entouré au moins partiellement côté périphérie par une gorge de logement (3).

3. Actionneur piézoélectrique selon la revendication 1 ou 2, **caractérisé en ce que**, sur la deuxième extrémité de convertisseur (2b) du convertisseur de flexion (2), est prévu un élément de maintien (10) en forme de cylindre, supporté de façon coulissante, transversalement par rapport à la direction de flexion vers l'extérieur (9) du convertisseur de flexion (2), par une gorge de logement (6).

4. Actionneur piézoélectrique selon l'une des revendications 1 à 3, **caractérisé en ce que** la première extrémité de convertisseur (2a) est réalisée sous forme d'extrémité de raccordement, susceptible d'être reliée à une source de tension électrique, du convertisseur de flexion (2), pour son actionnement.

5. Soupape (20) susceptible d'être actionnée de façon piézoélectrique, avec un actionneur (1) piézoélectrique, selon l'une des revendications précédentes, et avec au moins un canal de soupape (23, 24), susceptible d'être obturé à l'aide d'un élément d'étanchéité (26) qui est maintenu sur le convertisseur de flexion (2) piézoélectrique, la première extrémité de convertisseur (2a) du convertisseur de flexion (2) étant maintenue, de manière mobile en rotation, dans une première gorge de boîtier (3), prévue sur un côté de boîtier (30), dans le boîtier de soupape (2), et la deuxième extrémité de convertisseur (2b) du convertisseur de flexion (2) étant guidée, de manière mobile, sur le côté de boîtier (29), opposé à la première extrémité de convertisseur (2a), dans une deuxième gorge de boîtier (6), dans la direction longitudinale (8) du convertisseur.

6. Soupape susceptible d'être actionnée de façon piézoélectrique selon la revendication 5, **caractérisée en ce que** le convertisseur de flexion (2), à l'état sans tension, est courbé de manière concave en direction d'un premier canal de soupape (23).

7. Soupape susceptible d'être actionnée de façon piézoélectrique selon la revendication 6, **caractérisée en ce que** le deuxième canal de soupape (24) s'étend à l'intérieur du boîtier de soupape (21), jusqu'à la proximité efficace du convertisseur de flexion (2).

8. Soupape susceptible d'être actionnée de façon piézoélectrique selon l'une des revendications 5 à 7, **caractérisée en ce que** l'élément d'étanchéité (26) est disposé dans une zone médiane du convertisseur de flexion (2).

9. Soupape susceptible d'être actionnée de façon piézoélectrique selon la revendication 8, **caractérisée par** un élément d'étanchéité (26), efficace des deux côtés de la zone médiane du convertisseur de flexion (2).

10. Soupape susceptible d'être actionnée de façon piézoélectrique selon la revendication 8 ou 9, **caractérisée en ce que** l'élément d'étanchéité (26) présente un bombement d'étanchéité (26a ou 26b) orienté vers le canal de soupape (23, 24) respectif.
